# EUROPÄISCHE PATENTSCHRIFT

(11) **EP 0 931 850 B1**
(45) Veröffentlichungstag und Bekanntmachung des Hinweises auf die Patenterteilung: **15.01.2003**
(21) Anmeldenummer: 98121711.0
(22) Anmeldetag: 13.11.1998
(51) Int. Cl.: C23C 14/02, C23C 14/20, B05D 7/24

(54) **Verfahren zur Behandlung von Oberflächen von Substraten aus Kunststoff**
Method for treating the surfaces of plastic substrates
Procédé de traitement des surfaces des substrats en plastique

(30) Priorität: 26.01.1998 DE 19802740
(43) Veröffentlichungstag der Anmeldung: 28.07.1999
(73) Patentinhaber: Leybold Optics GmbH, 63775 Alzenau (DE)
(72) Erfinder: Grünwald, Heinrich Dr., 61194 Niddatal (DE); Nauenburg, Klaus Dr., 63456 Hanau (DE)
(74) Vertreter: Bockhorni, Josef, Dipl.-Ing.

(56) Entgegenhaltungen:
- EP-A- 0 282 094
- WO-A-98/32597
- US-A- 4 374 717
- US-A- 4 548 864
- PATENT ABSTRACTS OF JAPAN vol. 096, no. 004, 30. April 1996 & JP 07 316776 A (TOMOEGAWA PAPER CO LTD;OTHERS: 02), 5. Dezember 1995

## Beschreibung

Die Erfindung betrifft ein Verfahren zur Behandlung von Oberflächen von Substraten aus Kunststoff für das anschließende Überziehen mit feinen Metallschichten, insbesondere mit Kupfer.

Das Überziehen oder Metallisieren erfolgt im allgemeinen mittels physikalischer Dampfphasenbeschichtung ("Physical Vapour Deposition", PVD), wobei unter PVD alle Varianten des Bedampfens mit Metallen (thermisch, induktiv, mit Hilfe von anodischem oder kathodischem Lichtbogen, Elektronenoder Laserstrahl) und insbesondere die Kathodenzerstäubung (Sputtern) verstanden wird.

Die Haftung von Metallschichten auf Kunststoffen, hier verstanden als Haftfestigkeit (Widerstand gegen Abreißen) und Haftbeständigkeit (Konstanz des Widerstands gegen Abreißen nach längerer Einwirkung unterschiedlicher Temperaturen, Feuchtigkeit und chemischer Agenzien), ist ein allgemeines technisches Problem, z. B bei der Herstellung von Reflektoren, integrierten Schaltkreisen, elektrischen Abschirmungen, Verschlußdeckeln oder anderen Verpackungsteilen, Abdeck- und Zierblenden oder Gegenständen mit überwiegend dekorativer Funktion. Problematisch ist hierbei die Vielzahl der in der Technik anzutreffenden Kunststoffzusammensetzungen, die - auch bei gleichem Grundmaterial - sehr unterschiedliche Oberflächeneigenschaften haben können, so daß bei einem Wechsel des Kunststoffmaterials unterschiedliche Haftfestigkeiten entstehen können. Zusätzlich können Inhomogenitäten der Oberflächeneigenschaften von Kunststoffmaterialien, beispielsweise von spritzgegossenen Formteilen, zu unvorhergesehenen, lokalen Schichtablösungen führen.

Es sind in der Technik deshalb eine Reihe von Haftvorbehandlungsverfahren für Kunststoffmaterialien im Einsatz, die meist mit mehr oder minder drastischen mechanischen oder naßchemischen Mitteln wie Strahlen oder Ätzen die Kunststoffoberfläche abtragen und damit einen reinigenden und aufrauhenden Effekt erzielen. Neuerdings werden auch schonendere physikalische oder physikalischchemische Vorbehandlungen eingesetzt:

Es ist ein Verfahren zur Durchführung der Vorbehandlung und der nachfolgenden Metallisierung von Kunststoffen in einer Vakuumapparatur bekannt (Kupfer, Hecht, Schott: Metalloberfläche 50, Carl Hanser Verlag, München, 1996, S. 131 - 134), wobei die Kunststoffe durch Sauerstoffplasma gereinigt, aufgerauht, anoxidiert und anschließend mittels Magnetron-Sputtern mit Kupfer beschichtet werden.

Bekannt ist auch ein Verfahren (EP 0 206 145), bei dem zur Vorbehandlung des Kunststoffs Polyimid ein niederenergetischer Ionenstrahl, erzeugt aus reaktiven Gasen, wie z.B. Sauerstoff und Stickstoff, verwendet wird.

Weiterhin ist eine Haftfestvorbehandlung von Kunststoffen bekannt (DE 29 16 006), die für die Leiterplattenherstellung verwendet werden, vor allem Polyimid, Polyester und Epoxid, mit Schwerionenätzen vor dem Metallbedampfen bzw. Aufsputtern, wobei hier die Haftfestigkeit ausschließlich durch mechanische Effekte, wie eine extreme Aufrauhung der Kunststoffoberfläche bis hin zur Kavernenbildung, und nicht durch chemische Bindungen erreicht wird. Beiden letztgenannten Verfahren ist gemein, daß die Verwendung von Ionenstrahlen einen hohen apparativen Aufwand verlangt.

Bekannt ist auch die Herstellung einer CyanoGruppen enthaltenden Plasmapolymerschicht als Haftvermittler auf einem Polyimid-Film (JP 7316776), der anschließend mittels Kathodenzerstäubung oder Aufdampfen mit Kupfer beschichtet wird.

Man hat auch die Herstellung einer Haftvermittlerschicht für auf Polyurethanthermoplasten aufgesputtertes Chrom durch Plasmapolymerisation von Acetonitril vorgeschlagen (US 4,374,717).

Chrom ist bekanntermaßen von sich aus besser als Kupfer zum haftfesten Aufdampfen bzw. Aufsputtern auf Kunststoffe geeignet. In der Zeitschrift J. Adhesion Sci. Technol. 9 (1995) Nr. 4, S. 487-499 wird hierzu auf eine auf Polyimid aufgesputterte Zwischenschicht aus Chrom als Haftvermittler für gesputterte Kupferschichten hingewiesen.

Schließlich ist es bekannt (EP 0 282 094), daß zur Haftungsverbesserung einer Metallbeschichtung vornehmlich Aluminium, aber auch Chrom, Kupfer, Silber oder Gold auf eine Polyolefinfolie, im besonderen auf eine Polypropylenverpackungsfolie, eine aus gesättigten oder ungesättigten alphatischen Kohlenwasserstoffen (mit bis zu 12 Kohlenstoffatomen), insbesondere aus Ethylen bzw. Ethylen/Propylen-Mischungen erzeugte Plasmapolymerschicht abgeschieden wird. Hierbei wird beobachtet, daß die Haftung immer dann maximal ist, wenn durch die Anwendung sehr geringer Plasmaleistungen eine unpolare, äußerst dünne, weiche und wenig vernetzte Schicht erzeugt wird.

Da bei der Plasmapolymerisation (H. Yasuda: Plasma Polymerization, Academic Press, Orlando, 1985, Kap. 2, "Scope of Polymer Formation by Plasma Polymerization") das Ausgangsmaterial zur Bildung der Schicht einer mehr oder weniger intensiven Einwirkung eines Plasmas ausgesetzt wird, somit wenig spezifisch zersetzt und so zur Reaktion gebracht wird, entstehen in aller Regel Schichten mit wenig spezifischen Eigenschaften, so daß neben den für die Haftverbesserung erwünschten Strukturen auch weniger erwünschte entstehen. Eine weitere Konsequenz ist die Bildung einer Vielzahl von mehr oder minder flüchtigen, teils gesundheitsoder umweltgefährdenden Nebenprodukten, die einerseits die Reaktionskammer verschmutzen und andererseits als Abgase abgepumpt und entsorgt werden müssen.

Beschrieben ist auch (Feldmann, Franke, Beitinger: Metalloberfläche 49 (1995), S. 862 - 867) die grundsätzliche Möglichkeit des plasmainduzierten Pfropfens zur Verbesserung der Haftung von Kupfer auf Thermoplasten. Dieses Verfahren muß jedoch wegen komplizierter Führung der Prozesse und hoher Kosten als wenig vorteilhaft eingeschätzt werden.

Es besteht daher Bedarf nach einem möglichst gesundheitsverträglichen, umweltschonenden Verfahren zur Haftvorbehandlung von Kunststoffmaterialien vor einer PVD-Beschichtung mit Metallen, insbesondere von edleren Metallen wie Kupfer, das bei geringem Aufwand eine hohe Haftfestigkeit verschiedener Metalle auf einer großen Bandbreite von Kunststoffmaterialien ermöglicht. Das gewünschte Verfahren sollte mit den generell unter Vakuum durchgeführten PVD-Verfahren leicht zu verketten, bevorzugt in PVD-Anlagen integrierbar sein.

Die Erfindung erfüllt diesen Bedarf, indem mindestens eine haftvermittelnde Verbindung mittels plasmainduzierter Polymerisation in den Varianten plasmainitiierter Polymerisation oder plasmainitiierter Pfropfpolymerisation vor der Metallbeschichtung auf dem zu beschichtenden Kunststoffmaterial fixiert wird. Erfindungsgemäß besteht eine hierzu verwendbare, haftvermittelnde Verbindung aus mindestens einer metallkomplexierenden Funktion, einer Gerüstgruppe und einer radikalisch addierbaren oder polymerisierbaren Funktion.

Der Polymerisationsprozeß wird im Rahmen der Erfindung so geführt, daß die Struktur der haftvermittelnden Verbindung möglichst vollständig erhalten bleibt. Aus diesem Grund ist die bekannte Plasmapolymerisation wegen der unvermeidlichen Fragmentierung der haftvermittelnden Verbindung weniger geeignet. Der Erhalt der Struktur wird durch die Erfindung in zwei Varianten erreicht:
a) Plasmainitiierte Polymerisation:
   Die vorzubehandelnden Kunststoffteile werden nicht direkt einem Plasma ausgesetzt sondern mit einem Gasstrom (downstream), der aus einem Edelgas- oder Stickstoffplasma herausgeleitet wird und gleichzeitig mit dem Dampf oder Gas der haftvermittelnden Verbindung in Kontakt gebracht, wobei vermieden wird, die haftvermittelnde Verbindung durch das Plasma hindurchzuleiten. Dies geschieht, indem die haftvermittelnde Verbindung außerhalb des Plasmas möglichst nahe den Kunststoffteilen und möglichst auch strahlförmig gerichtet auf diese in die Reaktionskammer eingelassen wird. Bei dieser Anordnung werden durch längerlebige energiereiche Teilchen, die aus dem Plasma austreten, auf den Kunststoffteilen Radikalstellen erzeugt, die mit der polymerisierbaren Funktion der haftvermittelnden Verbindung reagieren, derart, daß diese fest in Form einzelner Moleküle, oligomerer oder polymerer Ketten an die Polymerketten an der Kunststoffoberfläche gebunden ("aufgepfropft") wird. Bei dieser Variante, der plasmainitiierten Polymerisation, besteht die Möglichkeit, daß aus dem Plasma austretende, energiereichen Teilchen, insbesondere solche mit besonders hoher Energie, insbesondere Ionen, Nebenreaktionen der haftvermittelnden Verbindung bewirken. Weiter kann ein Teil der Moleküle der haftvermittelnden Verbindung gegen den Gasstrom zurück diffundieren und ins Plasma gelangen, von wo ihre Fragmente wieder vom Gasstrom zu den Kunststoffteilen befördert werden. Diese können erwünscht sein, insofern die aufgepfropften Ketten miteinander vernetzt werden oder insofern hierdurch neue, metallkomplexierende Funktionen A erzeugt werden. In der Regel wird aber die Vernetzung eher von einem Verlust an metallkomplexierenden Funktionen begleitet und somit unerwünscht sein. Es ist deshalb in der Regel vorteilhaft, die Kunststoffteile genügend weit vom Plasma anzuordnen, um zu erreichen, daß die Konzentration der Teilchen mit unerwünscht hoher Energie, insbesondere der Ionen, genügend herabgesetzt ist, wobei sich die Entfernung zum Plasma nach der Art des durch das Plasma strömenden Gases, dem Druck und der in das Plasma eingespeisten Energie sowie der Reaktivität der Gerüstfunktion B und der metallkomplexierenden Funktion A bemißt. Auch die im Plasma erzeugte, kurzwellige UV-Strahlung kann in diesem Sinne abträglich sein und ist dann durch optisch dichte Blenden, im einfachsten Fall durch eine um mindestens 90° abgewinkelte Verbindungsleitung zwischen Plasma und den Kunststoffteilen am Kontakt mit den Kunststoffteilen zu hindern.
   Erfindungsgemäß wird das Plasma einer oder mehrerer zum Aufbringen der Metallschicht mittels Kathodenzerstäubung verwendeter Kathoden zur Initiierung der Polymerisation verwendet. Bevorzugt werden in diesem Fall Magnetronkathoden, bei denen das Plasma in unmittelbarer Nähe des abzustäubenden Metallvorrats, des sogenannten Metalltargets konzentriert wird. Die haftvermittelnde Verbindung wird während der Metallbeschichtung nur kurzzeitig zu Beginn des Beschichtungsvorgangs zugesetzt, da andernfalls die Metallschicht verunreinigt wird. Bevorzugt wird deshalb, die haftvermittelnde Verbindung vor dem Auftreffen des Metalls mit den Kunststoffteilen in Kontakt zu bringen und an die Kunststoffoberfläche zu absorbieren oder bevorzugt zu kondensieren, derart, daß die Kunststoffoberfläche bereits mit einer sehr dünnen Schicht der haftvermittelnden Verbindung überzogen ist, bevor die von der Kathodenzerstäubung ausgehenden, teilweise angeregten Metalldampf- und Edelgasteilchen auf sie auftreffen. Überraschenderweise wird unter diesen Bedingungen die Schicht der haftvermittelnden Verbindung polymerisiert und an die Kunststoffoberfläche angebunden. Es ist ein besonderer Vorteil dieser Ausgestaltung der Erfindung, daß keine gesonderte Plasmaerzeugungsvorrichtung mit zugeordneter Reaktionskammer neben der für die Metallisierung benötigten Kathodenerstäubungsvorrichtung erforderlich ist. Nachteilig ist unter Umständen eine geringe, nicht zu vermeidende Verschmutzung der Kathodenzerstäubungsvorrichtung und der aufgebrachten Metallschicht.
b) Plasmainitiierte Pfropfpolymerisation (="Plasmapfropfen"):
   Bei dieser Variante wird ein Edelgas- oder Stickstoffplasma in der Nähe der zu metallisierenden Teile gezündet, so daß es im Gegensatz zur plasmainitiierten Polymerisation direkt auf die Oberfläche der Kunststoffteile einwirkt. Hierdurch werden auf der Kunststoffoberfläche zahlreiche Radikale geschaffen, die auf der Oberfläche fest verankert sind und im Vakuum wenigstens einige Minuten stabil sind. Nach einer vorgegebenen Zeit von einigen Sekunden oder Minuten wird das Plasma beendet und sofort anschließend, ohne das Vakuum zu unterbrechen, mindestens eine gas- oder dampfförmige haftvermittelnde Verbindung in die Reaktionskammer eingelassen. Hierbei wird vorteilhafterweise die Reaktionskammer nicht abgepumpt.
   Alternativ werden die mit dem Plasma vorbehandelten Kunststoffteile sofort, ohne Unterbrechung des Vakuums in eine Lösung, Emulsion oder die Reinsubstanz einer haftvermittelnden Verbindung eingetaucht oder hiermit besprüht. Diese Ausführung der Erfindung hat jedoch den Nachteil, daß hierbei ein naßchemischer Prozeßschritt in eine Vakuumanlage integriert werden muß, was einen besonderen Aufwand bedeutet. Innerhalb von Sekunden oder wenigen Minuten reagieren die Radikale an der Kunststoffoberfläche mit den polymerisierbaren Funktionen C wie unter a) beschreiben, jedoch ohne Nebenreaktionen unter Bildung von fest angebundenen einzelnen Molekülen oder Ketten der haftvermittelnden Verbindung. Von besonderem Vorteil ist hierbei, daß keine unerwünschten Nebenreaktionen der haftvermittelnden Verbindung auftreten, so daß einerseits keine metallkomplexierenden Funktionen verloren gehen, was der Haftfestigkeit zugute kommt, und andererseits keine unerwünschten, unter Umständen gefährlichen Nebenprodukte entstehen. Entgegen dem in der Literatur vorliegenden Vorurteil stellte sich heraus, daß das Plasmapfropfen ein rasch verlaufender, effektiver, leicht zu kontrollierender und dabei wenig aufwendiger Prozeß ist. Der Einsatz an haftvermittelnden Verbindungen ist gering, insbesondere wenn während ihrer Reaktion an der Kunststoffoberfläche die Reaktionskammer nicht abgepumpt wird. Da die Pfropfreaktion mit den Radikalen an der Kunststoffoberfläche bei Abwesenheit eines Plasmas sehr viel spezifischer verläuft, entstehen neben einem nicht genutzten Überschuß an haftvermittelnden Verbindungen keine bedenklichen Abfallprodukte.

Gemäß der Erfindung sind die haftvermittelnden Verbindungen wie folgt aufgebaut:
A) Die metallkomplexierende Funktion wird entsprechend dem als Schicht aufzubringenden Metall ausgewählt, derart, daß sie hiermit möglichst temperatur- und hydrolysebeständige Komplexe bildet. Im Falle von Kupfer sind in diesem Sinne beispielsweise Nitril- (= Cyano-) oder Rhodanid-, besonders Imidazol-, Carboxyund ganz besonders β-ständige Carbonyl-Gruppen geeignet. Für innerhalb der elektrochemischen Spannungsreihe weniger edle Metalle als Kupfer sind auch Amino- und Hydroxi-Gruppen als komplexierende Funktionen, für edlere Metalle als Kupfer auch organische π-Bindungssysteme wie Vinylgruppen, Aromaten oder Heteroaromaten als mehrbindige komplexierende Funktionen geeignet.
B) Als Gerüstfunktion werden im Sinne der Erfindung aliphatische, cycloaliphatische, aromatische oder heteroaromatische organische Strukturen verwendet. Sie werden so gewählt, daß die Flüchtigkeit der haftvermittelnden Verbindung möglichst hoch und das Gefahrenpotential möglichst niedrig ist.
C) Als radikalisch addierbare oder polymerisierbare Funktion C eignen sich grundsätzlich alle funktionellen Gruppen, die genügend reaktiv sind, um an der Kunststoffoberfläche radikalische Additions- oder Polymerisationsreaktionen eingehen. Solche funktionelle Gruppen sind bevorzugt Olefin-, Azetylen-, oder Epoxigruppen, aber auch sonstige kleine und gespannte oder heterozyklische Ringe.

Geeignete haftvermittelnde Verbindungen sind:
1. Für Kupfer: Acrylnitril, bevorzugt Vinylimidazol, Acrylsäure, Methacrylsäure, Allylacetoacetat, Allylcyanoacetat, Allylacetoacetat, 2-Acetylpyrrol, Furan-2-methanthiol, Thiophen-2-carbaldehyd, Thiophen-2-nitril.
2. Für innerhalb der elektrochemischen Spannungsreihe unedlere Metalle als Kupfer: Acrylsäure, Methacrylsäure, Propenol, Propinol, Butinol, Allylacetoacetat, 2-Acetylcyclopentanon, Allylacetoacetat.
3. Für innerhalb der elektrochemischen Spannungsreihe edlere Metalle als Kupfer: Acrylsäure, Methacrylsäure, Isopren, Allylacetoacetat.

Die Erfindung läßt die verschiedensten Ausführungsmöglichkeiten zu; eine davon ist in der anhängenden Zeichnung anhand einer an sich bekannten, im Schnitt dargestellten Beschichtungsvorrichtung näher erläutert.

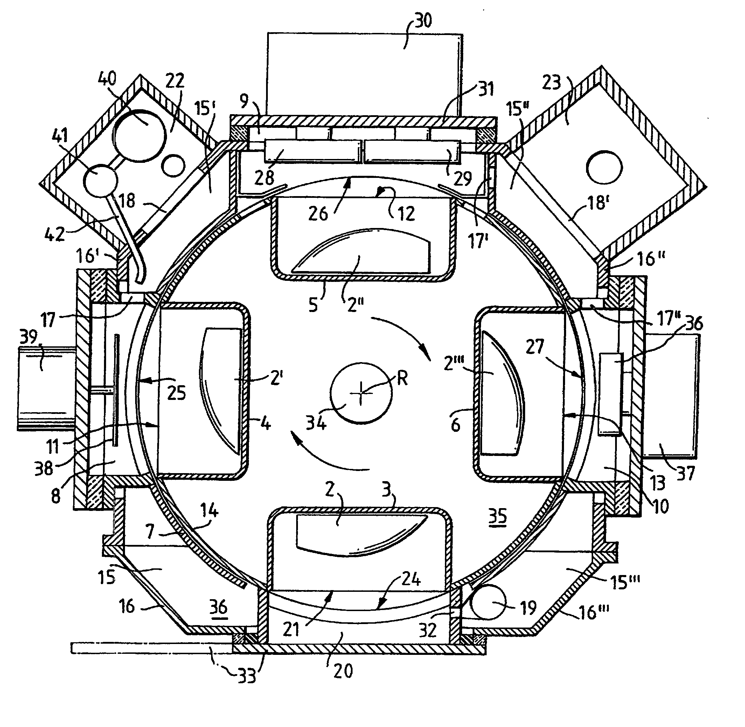

Die Vorrichtung weist eine kreiszylindrische Vakuumkammer 7 auf, die mit mehreren, gleichmäßig auf ihrer Mantelfläche verteilt angeordneten, fensterförmigen Öffnungen 24 bis 27 versehen ist, wobei jeder Öffnung 24 bis 27 eine Behandlungsstation 8,9,10 oder Ein-/Ausschleusstation 20 zugeordnet ist, die jeweils aus einem kastenförmigen, zur jeweiligen Öffnung 24 bis 27 hin offenen Gehäuse besteht, dessen umlaufende Randpartie mit der zylindrischen Wand der Vakuumkammer 7 fest verbunden ist. Die zylindrische Vakuumkammer 7 umschließt einen Innenzylinder 14, der mit Öffnungen 11,12,13,21 versehen ist, die mit den zuvor erwähnten Öffnungen in der Vakuumkammer 7 korrespondieren und in die kastenförmige Substratkammern 3 bis 6 eingesetzt sind, die zusammen mit den Behandlungsstationen 8,9,10 bzw. der Ein/Ausschleusstation 20 in der in der Zeichnung dargestellten Stellung des Innenzylinders 14 jeweils allseitig geschlossene Behältnisse bilden. Die kreiszylindrische Vakuumkammerwand 7 ist von Außenwandteilen 16,16',... umgriffen, die jeweils fest mit den Wandteilen der Behandlungsstationen 8,9,10 bzw. der Ein-/Ausschleusstation 20 verbunden sind und so zusammen mit der Kammerwand 7 Außenkammern 15,15',... bilden. Zwei dieser Außenkammern 15,15',... sind über Bohrungen 17,17' mit den Innenwänden zweier Behandlungsstationen 8,10 verbunden, wobei die Außenwände 16',16'' dieser beiden Außenkammern 15',15'' mit Quellen 22 bzw. 23 fest verbunden sind, über die Gase bzw. Monomere über Ausnehmungen 18,18' in die Außenkammern 15' bzw. 15'' einlaßbar sind. Im Gehäuse der Behandlungsstation 9 sind zwei Sputterkathoden 28,29 untergebracht, wobei die erforderlichen Stromversorgung 30 an der Außenwand 31 der Behandlungsstation 9 befestigt ist. In der Behandlungsstation 10 ist eine Sputterkathode 36 angeordnet, die mit der Stromversorgung 37 gekoppelt ist. Die Behandlungskammer 8 enthält eine Plasmaquelle 38, die von der Stromversorgung 39 gespeist wird. Die Außenkammer 15''' steht mit der Schleusenstation 20 über eine Bohrung 32 in Verbindung, die ihrerseits an den Saugstutzen 19 einer nicht näher dargestellten Vakuumpumpe angeschlossen ist. Zum Zwecke des Ein- bzw. Ausschleusens ist der Deckel 33 in die strichpunktiert eingezeichnete Stellung verschiebbar. Sämtliche Kammern, nämlich die Behandlungsstationen 8,9,10, die Schleusenkammer 20, die Substratkammern 3 bis 6, die Außenkammern 15,15', ... und der Innenzylinder 14 sind von einer gemeinsamen Bodenplatte 35 und einer nicht dargestellten Deckplatte abgedeckt, so daß sich ein besonders einfacher Aufbau der Vorrichtung ergibt. Es ist klar, daß der Innenzylinder mit der kreisscheibenförmigen Platte 35 mit dem Motor 34 in drehfester Verbindung stehen muß, damit das aus dem Innenzylinder und den Substratkammern 3 bis 6 bestehende Gebilde innerhalb der eigentlichen Vakuumkammer rotieren kann.

Ein aus Polybutylenterphthalat, PBT, bestehendes Kunststoffteil wird durch den geöffneten Deckel 33 hindurch in die Substratkammer 3 geladen. Hierbei ist der Innenzylinder 14 und über diesen die zentrale Kammer mittels Vakuumdichtungen gegen die an der Peripherie angeordneten Plasmabehandlungskammer 8, Sputterkammer 9, Sputterkammer 10 und Schleusenkammer 20 abgedichtet. Die Substratkammern 4,5,6 außer der Schleusenkammer 3 befinden sich hierbei unter Vakuum. Nach dem Beladen wird der Deckel 33 vakuumdicht verschlossen, die Ein/Ausschleusstation 20 evakuiert und anschließend das Kunststoffteil 2 durch eine Teilrotation des Innenzylinders 14 vor die Plasmabehandlungsstation 8 bewegt. Die Prozeßkammern sind wieder vakuumgedichtet und bei fortdauerndem Pumpen wird Argon als Prozeßgas über die Quelle 22 in die Plasmabehandlungskammer 8 eingelassen, so daß sich ein Druck von 10 Pa einstellt. Mit Erreichen dieses Drucks wird eine in der Plasmabehandlungsstation angebrachte Elektrode 38 vom Generator 39 mit einer mittelfrequenten Wechselspannung von 40 kHz und einer Leistung von 1 kW beaufschlagt und so ein Plasma gezündet. Nach 5 s wird gleichzeitig die Wechselspannung abgeschaltet, ein Ventil zur Pumpe geschlossen und dampfförmige Acrylsäure aus einem Vorratsgefäß 40 durch ein Ventil 41 hindurch über eine Leitung 42 in die Plasmabehandlungskammer 8 eingelassen. Nach 20 s wird das Ventil 41 geschlossen und die Plasmabehandlungskammer 8 evakuiert. Der Innenzylinder 14 wird erneut weitergedreht und das Substrat 2 in die Sputterkammer 5 bewegt. In die Behandlungskammer 5 wird unter fortdauerndem Pumpen Argon über die Quelle 23 eingelassen, so daß sich ein Prozeßdruck von 0,005 mbar einstellt. Nach Erreichen dieses Drucks werden die Kathoden 28,29, die mit Kupfertargets versehen sind, mit einer negativen Spannung von 800 V bei einer Leistung von 2 x 50 kW beaufschlagt und so der Kathodenzerstäubungsprozeß begonnen. Nach 25 s wird die Spannung von den Kathoden 28,29 genommen und so der Kathodenzerstäubungsprozeß beendet. Nach erfolgtem Weiterdrehen des Innenzylinders 14 gelangt des Substrat 2 vor die Kathode 36 und wird hier mit einer zusätzlichen Metallschicht versehen. Nach erneutem Weiterschalten des Innenzylinders 14 kann das Substrat 2 über die Öffnung 21 bei geöffnetem Deckel 33 ausgeschleust werden.

### Bezugszeichenliste

- 2,2': Substrat
- 3: Substratkammer
- 4: Substratkammer
- 5: Substratkammer
- 6: Substratkammer
- 7: kreiszylindrische Vakuumkammerwand
- 8: Behandlungsstation, Plasmabehandlungskammer
- 9: Behandlungsstation, Sputterkammer
- 10: Behandlungsstation, Sputterkammer
- 11: Öffnung
- 12: Öffnung
- 13: Öffnung
- 14: zylindrische Wand, Innenzylinder
- 15,15', ...: Außenkammer
- 16,16', ...: Außenwand
- 17,17', ...: Bohrung
- 18,18': Ausnehmung
- 19: Saugstutzen
- 20: Ein-/Ausschleusstation, Schleusenstation
- 21: Öffnung
- 22: Gas-Quelle
- 23: Gas-Quelle
- 24: Öffnung
- 25: Öffnung
- 26: Öffnung
- 27: Öffnung
- 28: Sputterkathode
- 29: Sputterkathode
- 30: Stromversorgung
- 31: Außenwand
- 32: Bohrung
- 33: Deckel, Schleusenklappe
- 34: Motor
- 35: Platte
- 36: Sputterkathode
- 37: Stromversorgung
- 38: Plasmaquelle, Elektrode
- 39: Stromversorgung, Generator
- 40: Acrylsäurebehälter
- 41: Ventil
- 42: Leitung

## Patentansprüche

1. Verfahren zur Behandlung von Oberflächen von Substraten aus Kunststoff für das anschließende Überziehen mit feinen Metallschichten, **dadurch gekennzeichnet, dass** das Substrat in einer Vakuumkammer einem aus einem Edelgas- oder Stickstoffplasma herausgeleiteten Gasstrom ausgesetzt und gleichzeitig mit dem Dampf oder Gas einer haftvermittelnden Verbindung in Kontakt gebracht wird oder dass auf das Substrat direkt ein Edelgas- oder Stickstoffplasma einwirkt und nachfolgend das Substrat mit dem Dampf oder Gas einer haflvermittelnden Verbindung in Kontakt gebracht wird, wobei der Dampf eine radikalisch polymerisierbare oder addierbare Verbindung mit Olefin-, Azetylen-, oder Epoxigruppen oder kleinen und gespannten oder heterozyklischen Ringen ist, und wobei die haftvermittelnde Verbindung eine Gerüstfunktion in Gestalt einer aliphatischen, cycloaliphatischen, aromatischen oder heteroaromatischen organischen Struktur sowie eine metallkomplexierende Funktion in Form von Nitril-, Mercapto-, Rhodanid-, Imidazol-, Carboxy-, Carbonyl- oder β-ständiger Carbonylgruppen enthält.

2. Verfahren zur Behandlung von Oberflächen von Substraten aus Kunststoff für das anschließende Überziehen mit feinen Metallschichten, **dadurch gekennzeichnet, dass** das Substrat in einer Vakuumkammer einem aus einem Edelgas- oder Stickstoffplasma herausgeleiteten Gasstrom ausgesetzt und gleichzeitig mit dem Dampf oder Gas einer haftvermittelnden Verbindung in Kontakt gebracht wird oder dass auf das Substrat direkt ein Edelgas- oder Stickstoffplasma einwirkt und nachfolgend das Substrat mit dem Dampf oder Gas einer haftvermittelnden Verbindung in Kontakt gebracht wird, wobei der Dampf eine radikalisch polymerisierbare oder addierbare Verbindung mit Olefin-, Azetylen-, oder Epoxigruppen oder kleinen und gespannten oder heterozyklischen Ringen ist, wobei die haftvermittelnde Verbindung eine Amino- oder Hydroxi-Gruppe ist.

3. Verfahren zur Behandlung von Oberflächen von Substraten aus Kunststoff für das anschließende Überziehen mit feinen Metallschichten, **dadurch gekennzeichnet, dass** das Substrat in einer Vakuumkammer einem aus einem Edelgas- oder Stickstoffplasma herausgeleiteten Gasstrom ausgesetzt und gleichzeitig mit dem Dampf oder Gas einer haftvermittelnden Verbindung in Kontakt gebracht wird oder dass auf das Substrat direkt ein Edelgas- oder Stickstoffplasma einwirkt und nachfolgend das Substrat mit dem Dampf oder Gas einer haftvermittelnden Verbindung in Kontakt gebracht wird, wobei der Dampf eine radikalisch polymerisierbare oder addierbare Verbindung mit Olefin-, Azetylen-, oder Epoxigruppen oder kleinen und gespannten oder heterozyklischen Ringen ist, wobei die haftvermittelnde Verbindung ein organisches π-Bindungssystem enthält, das beispielsweise von mindestens einer Vinylgruppe, einem Aromaten oder Heteroaromaten gebildet ist.

## Revendications

1. Procédé de traitement de surfaces de substrats en matière plastique pour le revêtement ultérieur par de fines couches métalliques, **caractérisé en ce que** le substrat est exposé à un flux de gaz composé de plasma de gaz rare ou de plasma d'azote dans une chambre à vide et est simultanément mis en contact avec la vapeur ou le gaz d'une combinaison chimique favorisant l'adhérence, ou **en ce que** un plasma de gaz rare ou de plasma d'azote agit directement sur le substrat et le substrat est ensuite mis en contact avec la vapeur ou le gaz d'une combinaison chimique favorisant l'adhérence, considérant que la vapeur est une combinaison chimique avec un groupement oléfine, acétylène ou époxy ou avec des cycles petits et tendus ou des hétérocycles, et considérant que la combinaison chimique favorisant l'adhérence contient une fonction à squelette carboné sous forme d'une structure organique aliphatique, cycloaliphatique, aromatique ou hétéro-aromatique ainsi qu'une fonction pouvant complexer avec un métal sous forme de groupement nitrile, mercapto, thiocyanate, imidazole, carboxy, carbonyle ou carbonyle en position β.

2. Procédé de traitement de surfaces de substrats en matière plastique pour le revêtement ultérieur par de fines couches métalliques, **caractérisé en ce que** le substrat est exposé à un flux de gaz composé de plasma de gaz rare ou de plasma d'azote dans une chambre à vide et est simultanément mis en contact avec la vapeur ou le gaz d'une combinaison chimique favorisant l'adhérence, ou **en ce que** un plasma de gaz rare ou de plasma d'azote agit directement sur le substrat et le substrat est ensuite mis en contact avec la vapeur ou le gaz d'une combinaison chimique favorisant l'adhérence, considérant que la vapeur est une combinaison chimique avec un groupement oléfine, acétylène ou époxy ou avec des cycles petits et tendus ou des hétérocycles, considérant que la combinaison chimique favorisant l'adhérence est un groupement amine ou hydroxyle.

3. Procédé de traitement de surfaces de substrats en matière plastique pour le revêtement ultérieur par de fines couches métalliques, **caractérisé en ce que** le substrat est exposé à un flux de gaz composé de plasma de gaz rare ou de plasma d'azote dans une chambre à vide et est simultanément mis en contact avec la vapeur ou le gaz d'une combinaison chimique favorisant l'adhérence, ou **en ce que** un plasma de gaz rare ou de plasma d'azote agit directement sur le substrat et le substrat est ensuite mis en contact avec la vapeur ou le gaz d'une combinaison chimique favorisant l'adhérence, considérant que la vapeur est une combinaison chimique avec un groupement oléfine, acétylène ou époxy ou avec des cycles petits et tendus ou des hétérocycles, et considérant que la combinaison chimique favorisant l'adhérence est un système organique à liaisons π qui est par exemple construit à partir d'au moins un groupement vinyle, d'un cycle aromatique ou d'un cycle hétéro-aromatique.

## Claims

1. A method for treating the surfaces of plastic substrates for subsequent covering by fine coatings of metal, **characterised in that** the substrate is exposed in a vacuum chamber to a stream of gas produced by a plasma of inert gas or of nitrogen and simultaneously brought into contact with the vapour or gas of a bond-imparting compound, or, that a plasma of inert gas or of nitrogen reacts directly with the substrate, with the substrate subsequently being brought into contact with the vapour or gas of a bond-imparting compound, whereby the vapour is a radically polymerizable or additionable compound having olefin, acetylene or epoxy groups or small and stressed or heterocyclic rings, and whereby the adhesion-producing compound comprises a framework function in the form of an aliphatic, cycloaliphatic, aromatic or heteroaromatic organic structure as well as a metal-complex forming function in the form of nitrite, mercapto, rhodanide, imidazole, carboxy, carbonyl or β-consistent carbonyl groups.

2. A method for treating the surfaces of plastic substrates for subsequent covering by fine coatings of metal, **characterised in that** the substrate is exposed in a vacuum chamber to a stream of gas produced by a plasma of inert gas or of nitrogen and simultaneously brought into contact with the vapour or gas of a bond-imparting compound, or, that a plasma of inert gas or of nitrogen reacts directly with the substrate, with the substrate subsequently being brought into contact with the vapour or gas of a bond-imparting compound, whereby the vapour is a radically polymerizable or additionable compound having olefine, acetylene or epoxy groups or small and stressed or heterocyclic rings, whereby the bond-imparting compound is an amino or hydroxy group.

3. A method for treating the surfaces of plastic substrates for subsequent covering by fine coatings of metal, **characterised in that** the substrate is exposed in a vacuum chamber to a stream of gas produced by a plasma of inert gas or of nitrogen and simultaneously brought into contact with the vapour or gas of a bond-imparting compound, or, that a plasma of inert gas or of nitrogen reacts directly with the substrate, with the substrate subsequently being brought into contact with the vapour or gas of a bond-imparting compound, whereby the vapour is a radically polymerizable or additionable compound having olefin, acetylene or epoxy groups or small and stressed or heterocyclic rings, whereby the bond-imparting compound comprises an organic π-bonding system which for example is formed from at least one vinyl group, an aromatic or heteroaromatic.
